(19) Europäisches Patentamt
European Patent Office
Office européen des brevets

(11) **EP 4 418 535 A1**

(12) **EUROPEAN PATENT APPLICATION**
published in accordance with Art. 153(4) EPC

(43) Date of publication:
**21.08.2024 Bulletin 2024/34**

(21) Application number: **21964360.8**

(22) Date of filing: **18.11.2021**

(51) International Patent Classification (IPC):
**H03F 1/32** *(2006.01)*

(52) Cooperative Patent Classification (CPC):
**H03F 1/32**

(86) International application number:
**PCT/CN2021/131414**

(87) International publication number:
**WO 2023/087200 (25.05.2023 Gazette 2023/21)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Huawei Technologies Co., Ltd.
Shenzhen, Guangdong 518129 (CN)**

(72) Inventors:
• **LUO, Yuping
Shenzhen, Guangdong 518129 (CN)**
• **WEI, Hongliang
Shenzhen, Guangdong 518129 (CN)**

• **LI, Jing
Shenzhen, Guangdong 518129 (CN)**
• **TANG, Haizheng
Shenzhen, Guangdong 518129 (CN)**
• **XIAO, Yuxiang
Shenzhen, Guangdong 518129 (CN)**
• **LU, Shaoting
Shenzhen, Guangdong 518129 (CN)**
• **WANG, Guangwei
Shenzhen, Guangdong 518129 (CN)**

(74) Representative: **MERH-IP Matias Erny Reichl
Hoffmann
Patentanwälte PartG mbB
Paul-Heyse-Strasse 29
80336 München (DE)**

(54) **SIGNAL PROCESSING APPARATUS AND COMMUNICATION DEVICE**

(57) This application provides a signal processing apparatus and a communication device, and relates to the field of communication technologies, to improve cancellation precision for a non-linear distortion signal. The apparatus includes a first splitter module, a first combiner module, a delayer, and a filter circuit. The first splitter module is coupled to a signal source of the signal processing apparatus, and an output end of the first splitter module is separately coupled to an input end of the delayer and an input end of the filter circuit. An output end of the delayer is coupled to a first input end of the first combiner module. An output end of the filter circuit is coupled to a second input end of the first combiner module. The filter circuit includes a plurality of filter sub-circuits and an accumulation circuit, and output ends of the plurality of filter sub-circuits are coupled to an input end of the accumulation circuit.

FIG. 3a

## Description

### TECHNICAL FIELD

This application relates to the field of communication technologies, and in particular, to a signal processing apparatus and a communication device.

### BACKGROUND

When a wanted signal (that is, a service signal) passes through a non-linear system, non-linear distortion occurs. For example, after power of the wanted signal is amplified by a power amplifier (power amplify, PA), an output signal includes the wanted signal and a non-linear distortion signal.

Currently, a feedforward cancellation technology is usually used to cancel a non-linear distortion component in the output signal of the non-linear system. However, processing precision of the existing feedforward cancellation technology is low, and consequently, a cancellation effect for the non-linear distortion component is poor, and further, poor performance of a communication system is caused.

### SUMMARY

This application provides a signal processing apparatus and a communication device, to improve cancellation precision for a non-linear distortion signal.

To achieve the foregoing objective, the following technical solution is used in embodiments of this application.

According to a first aspect, a signal processing apparatus is provided, and includes a first splitter module, a delayer, a first combiner module, and a filter circuit. The first splitter module may be a component such as a coupler or a splitter, and a first coupler is used as an example of the first splitter module below for description. The first combiner module may be a component such as a coupler or a combiner, and a second coupler is used as an example of the first combiner module below for description. In other words, the signal processing apparatus includes the first coupler, the second coupler, the delayer, and the filter circuit. The first coupler is coupled to a signal source of the signal processing apparatus, and an output end of the first coupler is separately coupled to an input end of the delayer and an input end of the filter circuit. An output end of the delayer is coupled to a first input end of the second coupler. An output end of the filter circuit is coupled to a second input end of the second coupler. The filter circuit includes a plurality of filter sub-circuits and an accumulation circuit, and output ends of the plurality of filter sub-circuits are coupled to an input end of the accumulation circuit.

The first coupler is configured to output a first sub-signal and a second sub-signal based on an input signal of the first coupler, and power of the first sub-signal may be greater than power of the second sub-signal. The delayer is configured to delay the first sub-signal to output a delayed signal. The filter circuit includes the plurality of filter sub-circuits and the accumulation circuit. The plurality of filter sub-circuits are separately configured to sample the second sub-signal at different sampling moments, and perform filtering processing on sampled signals obtained through sampling, to output sampled and filtered signals. In other words, the plurality of filter sub-circuits may be separately configured to adjust an amplitude of the second sub-signal in different phases. The accumulation circuit is configured to accumulate the sampled and filtered signals output by the plurality of filter sub-circuits, to obtain an intermodulation cancellation signal. The second coupler is configured to output a target signal based on the intermodulation cancellation signal and the delayed signal, for example, subtract the intermodulation cancellation signal from the delayed signal to cancel an intermodulation signal in the delayed signal.

In the foregoing technical solution, the apparatus implements equalization processing on the second sub-signal by using the filter circuit. The filter circuit includes the plurality of filter sub-circuits and the accumulation circuit. The plurality of filter sub-circuits and the accumulation circuit can perform high-precision amplitude adjustment on the second sub-signal in different phases in an analog signal domain, so that equalization processing on the intermodulation signal can be implemented when the delayer provides an extremely small delay, thereby reducing a processing delay and improving processing precision.

In a possible implementation of the first aspect, the apparatus further includes a second combiner module. A third coupler is used as an example of the second combiner module below for description. A first input end of the third coupler is coupled to the output end of the first coupler, a second input end of the third coupler is coupled to the signal source, and an output end of the third coupler is coupled to the input end of the filter circuit. The third coupler is configured to obtain a first intermodulation signal from the second sub-signal through coupling. The third coupler may be replaced with an equalizer, and output the first intermodulation signal. In this case, the plurality of filter sub-circuits are separately configured to sample the first intermodulation signal in the second sub-signal at different sampling moments, and perform filtering processing on sampled signals obtained through sampling, to output sampled and filtered signals. In other words, the plurality of filter sub-circuits may be separately configured to adjust an amplitude of the first intermodulation signal in different phases. Through introduction of the third coupler (the second combiner module) or the equalizer, the first intermodulation signal in the second sub-signal may be extracted, so that the filter circuit can perform, in a targeted manner, high-precision amplitude-phase adjustment on the first intermodulation signal, and a component of a service signal in an intermodulation cancellation signal output by the filter circuit can be reduced. Therefore, adverse impact exerted by the intermodulation cancellation signal on a wanted signal component in the delayed signal can be reduced, and cancellation performance of the intermodulation signal can be further improved.

It may be understood that, when the apparatus does not include a combiner module, the first intermodulation signal processed by the filter circuit and the filter sub-circuit is replaced with the second sub-signal.

In a possible implementation of the first aspect, each of the plurality of filter sub-circuits includes a sample-and-hold circuit and an amplitude adjustment circuit. An output end of the sample-and-hold circuit is coupled to a first input end of the amplitude adjustment circuit. The sample-and-hold circuit is configured to sample and keep the first intermodulation signal at the sampling moment, to output a sampled signal. The amplitude adjustment circuit is configured to perform filtering processing on the sampled signal, to output the sampled and filtered signal. In the foregoing possible implementation, the plurality of filter sub-circuits can separately adjust the amplitude of the first intermodulation signal in different phases, to ensure that equalization processing on the intermodulation signal has relatively high processing precision.

In a possible implementation of the first aspect, the sample-and-hold circuit includes a switch, a capacitor, and a buffer, and the amplitude adjustment circuit includes a multiplier. A first end of the switch is an input end of the filter sub-circuit, and a second end of the switch, a first end of the capacitor, and a first end of the buffer are coupled. A second end of the capacitor is grounded. A second end of the buffer is coupled to a first input end of the multiplier. A second input end of the multiplier is configured to receive a filtering coefficient, and an output end of the multiplier is configured to output the sampled and filtered signal. In the foregoing possible implementation, the provided sample-and-hold circuit and the provided amplitude adjustment circuit are simple and effective, and costs are low. In addition, when the sample-and-hold circuit and the amplitude adjustment circuit sample and keep and perform filtering processing on the first intermodulation signal, high-precision amplitude-phase adjustment of the first intermodulation signal in the intermodulation signal can be implemented with an extremely small delay, thereby reducing a processing delay and improving processing precision.

In a possible implementation of the first aspect, the amplitude adjustment circuit further includes a transconductance amplifier coupled to the output end of the multiplier, and the transconductance amplifier is configured to amplify the sampled and filtered signal; and/or the filter circuit further includes a variable-gain amplifier coupled to an output end of the accumulation circuit. In the foregoing possible implementation, it can be ensured that an amplitude of the intermodulation cancellation signal matches an amplitude of the intermodulation signal in the delayed signal, thereby improving a cancellation effect for the intermodulation signal in the delayed signal.

In a possible implementation of the first aspect, the apparatus further includes an attenuator. The attenuator is coupled between the first coupler and the third coupler, and the attenuator is configured to attenuate the second sub-signal, so that an amplitude of the second sub-signal matches an amplitude of a service signal that is input to the third coupler.

In a possible implementation of the first aspect, the first input end of the third coupler is coupled to the output end of the filter circuit, the second input end of the third coupler is coupled to the signal source, and the output end of the third coupler is coupled to the second coupler. Optionally, the apparatus further includes an amplifier coupled between the signal source and the third coupler.

In a possible implementation of the first aspect, the apparatus further includes a post-distortion circuit coupled to the third coupler and the signal source. The post-distortion circuit is configured to inject a second intermodulation signal into a signal (which may be understood as a first service signal) output by the signal source, to obtain a second service signal. The second service signal and the second sub-signal are used to obtain the first intermodulation signal through coupling, and a frequency of the second intermodulation signal is different from a frequency of the first intermodulation signal. Optionally, a difference between the frequency of the second intermodulation signal and a frequency of the first service signal is greater than a preset threshold. In the foregoing possible implementation, the post-distortion circuit injects the second intermodulation signal into the first service signal to obtain the second service signal, so that the third coupler obtains the first intermodulation signal from the second sub-signal through coupling by using the second service signal, thereby ensuring that the first intermodulation signal obtained through coupling is an intermodulation signal within a specific frequency band range, reducing complexity of processing the first intermodulation signal by the filter circuit, and reducing costs.

In a possible implementation of the first aspect, the apparatus further includes a pre-distortion circuit, configured to inject a third intermodulation signal into the first service signal. A difference between a frequency of the third intermodulation signal and the frequency of the first service signal is less than a first threshold. The third intermodulation signal may be referred to as a near-end intermodulation signal, and the third intermodulation signal is used to reduce the first intermodulation signal in the input signal of the first coupler. In the foregoing possible implementation, the third intermodulation signal is injected into the first service signal, and the first intermodulation signal in the input signal of the first coupler is reduced by using the third intermodulation signal, so that processing difficulty of processing the first intermodulation signal by the filter circuit can be reduced, and costs can be reduced.

In a possible implementation of the first aspect, the apparatus further includes a filtering coefficient calculation circuit. An output end of the filtering coefficient calculation circuit is coupled to a second input end of the amplitude adjustment circuit. The filtering coefficient calculation circuit is configured to output a plurality of filtering coefficients based on the first intermodulation signal and the target signal, and the plurality of filtering coefficients are filtering coefficients of the plurality of filter sub-circuits. Optionally, the filtering coefficient calculation circuit includes a second splitter module and a calculation circuit. For example, the second splitter module is a fourth coupler. The filtering calculation circuit includes the fourth coupler and the calculation circuit. An input end of the fourth coupler is coupled to an output end of the second coupler, a first output end of the fourth coupler is coupled to a first input end of the calculation circuit, and a second input end of the calculation circuit is configured to receive the first intermodulation signal. In the foregoing possible implementation, the filtering coefficient calculation circuit is configured to output the plurality of filtering coefficients of the plurality of filter sub-circuits based on the first intermodulation signal and the target signal, so that when filtering processing is performed on the first intermodulation signal based on the plurality of filtering coefficients, processing precision of the filter circuit can be improved.

In a possible implementation of the first aspect, the filtering coefficient calculation circuit further includes a first switch circuit and a second switch circuit that are coupled between the fourth coupler and the calculation circuit, and the first switch circuit and the second switch circuit are configured to disconnect or connect the fourth coupler and the calculation circuit. In the foregoing possible implementation, a hardware link between the first switch circuit and the second switch circuit may implement time division multiplexing; to be specific, a plurality of fourth couplers share one calculation circuit by disconnecting and connecting the first switch circuit and the second switch circuit, to improve utilization of the hardware link and reduce costs.

In a possible implementation of the first aspect, the apparatus further includes a parameter calibration circuit coupled to the filter circuit. The parameter calibration circuit is configured to determine a mismatch parameter of the filter circuit based on the first intermodulation signal and the intermodulation cancellation signal, and the mismatch parameter is used to calibrate the filter circuit. Optionally, the mismatch parameter includes at least one of the following: a sampling moment mismatch value, a gain mismatch value, or a direct current mismatch value. In the foregoing possible implementation, the parameter calibration circuit is used to calibrate the filter circuit based on the mismatch parameter that is output based on the first intermodulation signal and the intermodulation cancellation signal, so that a filtering efficiency difference caused between the plurality of filter sub-circuits in the filter circuit due to a manufacturing difference between components can be avoided, thereby improving processing precision of the filter circuit.

In a possible implementation of the first aspect, the filter circuit is integrated into one chip with at least one of the following: the filtering coefficient calculation circuit, the parameter calibration circuit, or the post-distortion circuit. In the foregoing possible implementation, the foregoing circuit is integrated into the chip, so that a size and costs of a system can be reduced.

In a possible implementation of the first aspect, the apparatus further includes a power amplifier coupled between an input end of the first coupler and the signal source and a duplexer coupled to the output end of the second coupler. The power amplifier is configured to output the input signal of the first coupler, and the duplexer is configured to receive the target signal and perform transmit filtering processing on the target signal. In the foregoing possible implementation, impact exerted on a receive signal in the duplex by the target signal when the target signal passes through the duplexer can be avoided.

According to a second aspect, a chip is provided. The chip includes a filter circuit. The filter circuit includes a plurality of filter sub-circuits and an accumulation circuit. The plurality of filter sub-circuits are separately configured to sample a first intermodulation signal at different sampling moments, and perform filtering processing on sampled signals obtained through sampling, to output sampled and filtered signals. The accumulation circuit is configured to accumulate the sampled and filtered signals output by the plurality of filter sub-circuits, to obtain an intermodulation cancellation signal.

In a possible implementation of the second aspect, each of the plurality of filter sub-circuits includes: a sample-and-hold circuit, configured to sample and keep the first intermodulation signal at the sampling moment, to output a sampled signal; and an amplitude adjustment circuit, configured to perform filtering processing on the sampled signal, to output the sampled and filtered signal.

In a possible implementation of the second aspect, the sample-and-hold circuit includes a switch, a capacitor, and a buffer, and the amplitude adjustment circuit includes a multiplier. A first end of the switch is an input end of the filter sub-circuit, and a second end of the switch, a first end of the capacitor, and a first end of the buffer are coupled. A second end of the capacitor is grounded. A second end of the buffer is coupled to a first input end of the multiplier. A second input end of the multiplier is configured to receive a filtering coefficient, and an output end of the multiplier is configured to output the sampled and filtered signal.

In a possible implementation of the second aspect, the amplitude adjustment circuit further includes a transconductance amplifier coupled to the output end of the multiplier, and the transconductance amplifier is configured to amplify the sampled and filtered signal.

In a possible implementation of the second aspect, the filter circuit further includes a gain amplifier coupled to an output end of the accumulation circuit.

In a possible implementation of the second aspect, the chip further includes a post-distortion circuit. The post-distortion circuit is configured to inject a second intermodulation signal into a first service signal to obtain a second service signal, the second service signal and a second transmit sub-signal are used to output the first intermodulation signal, and a frequency of the second intermodulation signal is different from a frequency of the first intermodulation signal.

In a possible implementation of the second aspect, a difference between the frequency of the second intermodulation signal and a frequency of the first service signal is greater than a preset threshold.

In a possible implementation of the second aspect, the chip further includes a filtering coefficient calculation circuit. The filtering coefficient calculation circuit is configured to output a plurality of filtering coefficients based on the first intermodulation signal and a target signal, and the plurality of filtering coefficients are filtering coefficients of the plurality of filter sub-circuits.

In a possible implementation of the second aspect, the chip further includes a parameter calibration circuit coupled to the filter circuit. The parameter calibration circuit is configured to determine a mismatch parameter of the filter circuit based on the first intermodulation signal and the intermodulation cancellation signal, and the mismatch parameter is used to calibrate the filter circuit.

In a possible implementation of the second aspect, the mismatch parameter includes at least one of the following: a sampling moment mismatch value, a gain mismatch value, or a direct current mismatch value.

According to a third aspect, a filtering coefficient calculation circuit is provided, and is applied to the signal processing apparatus provided in the first aspect. A first input end of the filtering coefficient calculation circuit is coupled to an output end of a second coupler, and a second input end of the filtering coefficient calculation circuit is configured to receive a first intermodulation signal. The first intermodulation signal is an input signal of the filter circuit. An output end of the filtering coefficient calculation circuit is configured to output a filtering coefficient of the filter circuit.

In a possible implementation of the third aspect, the filtering coefficient calculation circuit includes a third coupler and a calculation circuit. An input end of the third coupler is coupled to the output end of the second coupler, and a first output end of the third coupler is coupled to a first input end of the calculation circuit. A second input end of the calculation circuit is configured to receive the first intermodulation signal, and an output end of the calculation circuit is configured to output the filtering coefficient of the filter circuit.

In a possible implementation of the third aspect, the filtering coefficient calculation circuit further includes a first switch circuit and a second switch circuit that are coupled between the third coupler and the calculation circuit, and the first switch circuit and the second switch circuit are configured to disconnect or connect the third coupler and the calculation circuit. In the foregoing possible implementation, a hardware link between the first switch circuit and the second switch circuit may implement time division multiplexing; to be specific, the hardware link is switched by disconnecting and connecting the first switch circuit and the second switch circuit, to improve utilization of the hardware link and reduce costs.

According to a fourth aspect, a communication device is provided. The communication device includes a baseband circuit and the signal processing apparatus provided in the first aspect or any possible implementation of the first aspect.

It may be understood that any one of the chip, the filtering coefficient calculation circuit, and the communication device provided above includes at least a part of content of the signal processing apparatus provided above. Therefore, for beneficial effects that can be achieved by any one of the chip, the filtering coefficient calculation circuit, and the communication device, refer to the beneficial effects of the signal processing apparatus provided above. Details are not described herein again.

## BRIEF DESCRIPTION OF DRAWINGS

FIG. 1 is a schematic of a structure of a wireless communication device according to an embodiment of this application;
FIG. 2 is a schematic of a structure of a feedforward cancellation system according to an embodiment of this application;
FIG. 3a to FIG. 3d are schematics of a structure of a signal processing apparatus according to an embodiment of this application;
FIG. 4 is a schematic of a structure of a filter circuit according to an embodiment of this application;
FIG. 5 is a schematic of a structure of another filter circuit according to an embodiment of this application;
FIG. 6 is a diagram of a working time sequence of a filter circuit according to an embodiment of this application;

FIG. 7 is a schematic of a structure of another signal processing apparatus according to an embodiment of this application;

FIG. 8 is a schematic of a structure of still another signal processing apparatus according to an embodiment of this application; and

FIG. 9 is a schematic of a structure of another signal processing apparatus according to an embodiment of this application.

## DESCRIPTION OF EMBODIMENTS

The technical solutions in embodiments of this application are described below with reference to the accompanying drawings in embodiments of this application.

In this application, "at least one" means one or more, "a plurality of" means two or more, and "and/or" describes an association relationship between associated objects, and represents that three relationships may exist. For example, A and/or B may represent the following cases: only A exists, both A and B exist, and only B exists, where A and B may be singular or plural. The character "/" generally indicates an "or" relationship between associated objects. "At least one item (piece) of the following" or a similar expression thereof means any combination of these items, including a singular item (piece) or any combination of plural items (pieces). For example, at least one item (piece) of a, b, or c may represent: a, b, c, a and b, a and c, b and c, or a, b, and c, where a, b, and c may be singular or plural.

In embodiments of this application, words such as "first" and "second" do not limit a quantity and a sequence. The word "coupling" is used for representing an electrical connection, including a direct connection through a wire or a connection end or an indirect connection through another component. Therefore, "coupling" should be considered as a generalized electronic communication connection.

It should be noted that in this application, terms such as "example" or "for example" are used to represent giving an example, an illustration, or a description. Any embodiment or design scheme described as an "example" or "for example" in this application should not be explained as being more preferred or having more advantages than another embodiment or design scheme. To be precise, use of the word such as "example" or "for example" is intended to present a relative concept in a specific manner.

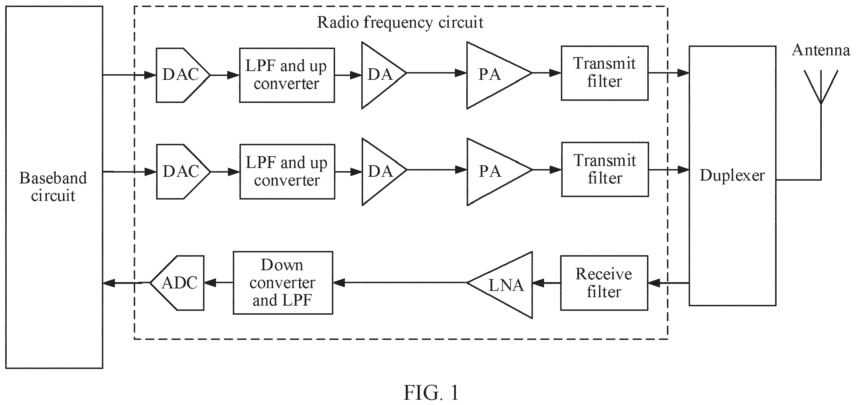

FIG. 1 is a schematic of a structure of a wireless communication device according to an embodiment of this application. The wireless communication device may be deployed on land, including indoor, outdoor, handheld, or vehicle-mounted. The wireless communication device may be alternatively deployed on a water surface (for example, a ship). The wireless communication device may be alternatively deployed in the air (for example, on an airplane, a balloon, or a satellite). For example, the wireless communication device may be a terminal or a base station. For example, the terminal includes but is not limited to a mobile phone (mobile phone), a tablet computer, a notebook computer, a palmtop computer, a mobile Internet device (mobile Internet device, MID), a wearable device (such as a smart watch, a smart band, or a pedometer), a vehicle-mounted device (such as an automobile, a bicycle, an electric vehicle, an aircraft, a ship, a train, or a high-speed train), a virtual reality (virtual reality, VR) device, an augmented reality (augmented reality, AR) device, a wireless terminal in industrial control (industrial control), a smart home device (such as a refrigerator, a television, an air conditioner, or an electricity meter), an intelligent robot, a workshop device, a wireless terminal in self-driving (self-driving), a wireless terminal in remote medical surgery (remote medical surgery), a wireless terminal in a smart grid (smart grid), a wireless terminal in transportation safety (transportation safety), a wireless terminal in a smart city (smart city), a wireless terminal in a smart home (smart home), a flight device (such as an intelligent robot, a hot air balloon, an unmanned aerial vehicle, or an aircraft), and the like. A structure of the wireless communication device is described in detail below with reference to FIG. 1.

The wireless communication device shown in FIG. 1 includes a baseband circuit, a radio frequency (radio frequency, RF) circuit, and an antenna (antenna) that are sequentially coupled.

The baseband circuit has a baseband processing function, and may be configured to process a baseband signal. The radio frequency circuit may be configured to provide a function such as power amplification or filtering. For example, the radio frequency circuit may be configured to perform power amplification or filtering on the baseband signal, to convert the baseband signal into a radio frequency signal. The antenna may be configured to receive or send a radio frequency signal, that is, convert energy between the radio frequency signal and an electromagnetic wave.

The radio frequency circuit may include one or more transmit (transmit, Tx) channels and one or more receive (receive, Rx) channels. Each transmit channel includes a power amplifier (power amplifier, PA). The transmit channel may further include a transmit filter (Tx filter), and the transmit filter may be an isolator. Each receive channel includes a low noise amplifier (low noise amplifier, LNA). The receive channel may further include a receive filter (Rx filter), and the receiver may be a surface acoustic wave filter (surface acoustic wave filter, SAW filter).

Further, the radio frequency circuit may be configured to implement modulation or demodulation between the baseband signal and the radio frequency signal. For example, the radio frequency circuit may further include a modulation circuit corresponding to the transmit channel and a demodulation circuit corresponding to the receive channel. The modulation circuit corresponding to the transmit channel may include a digital-to-analog converter (digital to analog converter, DAC), a low-pass filter (low pass filter, LPF), an up converter (up converter), and a driver amplifier (driver amplifier, DA). The demodulation circuit corresponding to the receive channel may include an analog-to-digital converter (analog to digital converter, ADC), a low-pass filter (low pass filter, LPF), a down converter (down converter), and the like.

When the communication device shown in FIG. 1 supports frequency division duplexing (frequency division duplexing, FDD), to isolate a transmit signal and a receive signal and ensure that receiving and transmitting can work at the same time, the communication device further includes a duplexer. As shown in FIG. 1, the duplexer may be located between the radio frequency circuit and the antenna. The duplexer is a special bidirectional three-end filter, and includes a transmit filter and a receive filter that may perform filtering suppression on the transmit signal and the receive signal respectively, to isolate the transmit signal and the receive signal and ensure that receiving and transmitting can work at the same time. A plurality of transmit channels and a plurality of receive channels in the radio frequency circuit may share one duplexer.

The transmit filter in the duplexer has the following two requirements: One is to ensure that an interference signal that has been suppressed by the transmit filter and that falls into a receive frequency band does not affect receiving sensitivity of a receive end. The other is to ensure that an interference signal that has been suppressed by the transmit filter and that falls outside the receive frequency band meets a stipulated spurious transmit index. The foregoing requirements may be implemented by improving a suppression degree of the transmit filter in the duplexer. However, this also causes a larger size of the transmit filter and higher costs.

To reduce the suppression degree of the transmit filter in the duplexer, a feedforward cancellation system may be used to cancel a non-linear distortion signal in a transmit signal that is input into the duplexer, to reduce impact exerted by the non-linear distortion signal on the receiving sensitivity and the spurious transmit index. The non-linear distortion signal is generated due to non-linear operation of components on the transmit channel, and is mainly generated due to non-linear operation of the PA on the transmit channel. The non-linear distortion signal mainly includes an intermodulation signal, and the intermodulation signal is a signal generated by mutual modulation between an interference signal or a noise signal and a wanted signal (which may also be referred to as a service signal). The non-linear distortion signal may further include a harmonic signal. For ease of description, an intermodulation signal is used below to represent the non-linear distortion signal.

A feedforward cancellation system is described in detail below.

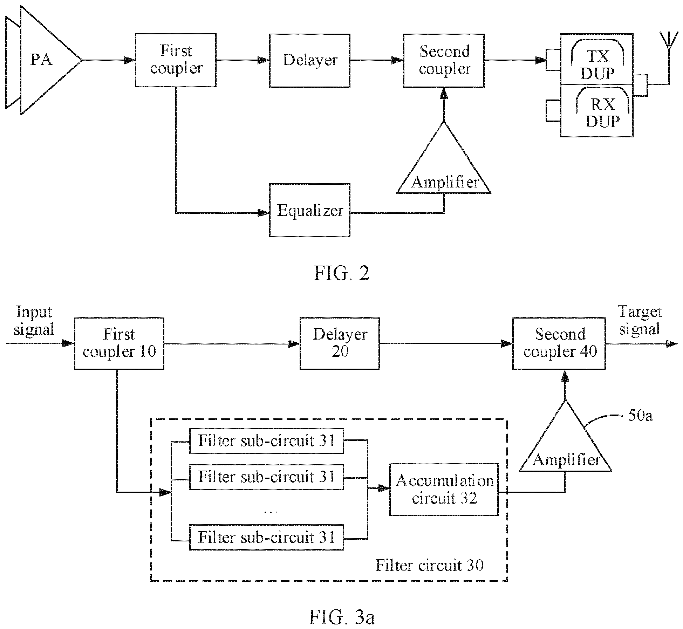

FIG. 2 is a schematic of a structure of a feedforward cancellation system according to an embodiment of this application. The system may be located between a PA on a transmit channel and a duplexer. As shown in FIG. 2, the feedforward cancellation system includes a first coupler, a delayer, an equalizer, an amplifier, and a second coupler. An input end of the first coupler is coupled to the PA, and an output end of the second coupler is coupled to a transmit filter in a duplexer. Specifically, the first coupler is configured to output two transmit sub-signals based on a transmit signal output by the PA; the equalizer is configured to adjust an amplitude and a phase of an intermodulation signal in one of the transmit sub-signals to output a cancellation signal; the amplifier is configured to amplify the cancellation signal to match power of an intermodulation signal in the other transmit sub-signal; the delayer is configured to delay the other transmit sub-signal to output a transmit delayed signal, where the delay is used to match a processing delay of the equalizer and a processing delay of the amplifier; and the second coupler is configured to cancel an intermodulation signal in the transmit delayed signal based on the amplified cancellation signal. The equalizer may be implemented by using a limiter, a band-stop filter, and a phase shifter that are sequentially coupled. The limiter may be configured to adjust an amplitude of an input signal; the band-stop filter may be configured to extract the intermodulation signal; and the phase shifter is configured to adjust a phase of the intermodulation signal. The equalizer may be alternatively implemented by using an ADC, a digital filter, a digital equalizer, and a DAC that are sequentially coupled. The digital filter is configured to extract the intermodulation signal, and the digital filter is configured to perform amplitude-phase equalization processing on the intermodulation signal. Alternatively, the equalizer may be specifically implemented in another manner. However, processing precision of an existing feedforward cancellation technology is low, and consequently, a cancellation effect for a non-linear distortion component is poor, and further, poor performance of a communication system is caused.

Based on this, an embodiment of this application provides a signal processing apparatus shown in FIG. 3a to FIG. 3d (the signal processing apparatus may also be referred to as a feedforward cancellation system). A plurality of filter sub-circuits are used to separately perform sampling and filtering processing on an intermodulation signal at different sampling moments, and an accumulation circuit accumulates sampled and filtered signals output by the plurality of filter sub-circuits, to obtain an intermodulation cancellation signal. Therefore, high-precision amplitude-phase adjustment of the intermodulation signal is implemented in an analog signal domain, thereby reducing a processing delay and improving processing precision.

The signal processing apparatus may be applied to the foregoing communication device that supports FDD, and may also be applied to a communication device that supports another duplex communication, or may be applied to a communication device that does not support or use duplex communication, to reduce impact exerted by a non-linear distortion signal on the communication device. The another duplex communication may include a time division duplexing (time division duplexing, TDD) communication scenario and an FDD+TDD communication scenario.

It may be understood that the signal processing apparatus may be disposed between a PA on a transmit channel and a transmit filter in a duplexer, or may be disposed between a PA on a transmit channel and a transmit filter on the transmit channel. Further, a component with non-linear distortion in the communication device may be directly or indirectly connected to an input end of the signal processing apparatus, to cancel, by using the signal processing apparatus, non-linear distortion introduced by the component.

The signal processing apparatus is described below.

FIG. 3a to FIG. 3d are schematics of a structure of a signal processing apparatus according to an embodiment of this application. The signal processing apparatus includes a splitter module #11, a delayer 20, a combiner module #21, and a filter circuit 30. The splitter module #11 may be a component such as a coupler, a splitter, or the like, and an example in which a first coupler 10 is the splitter module #1 is used below for description. The combiner module #21 may be a component such as a coupler, a combiner, or the like, and an example in which a second coupler 40 is the combiner module #21 is used below for description. It may be understood that the splitter module #11 and the combiner module #21 may be alternatively implemented in another manner. This is not limited in this application.

Based on the foregoing description, the signal processing apparatus shown in FIG. 3a includes the first coupler 10, the delayer 20, the second coupler 40, and the filter circuit 30.

An input end of the first coupler 10 is coupled to a signal source of the signal processing apparatus; an output end of the first coupler 10 is separately coupled to an input end of the delayer 20 and an input end of the filter circuit 30; an output end of the delayer 20 is coupled to a first input end of the second coupler 40; and an output end of the filter circuit 30 is coupled to a second input end of the second coupler 40. The filter circuit 30 includes a plurality of filter sub-circuits 31 and an accumulation circuit 32, and output ends of the plurality of filter sub-circuits 31 are coupled to an input end of the accumulation circuit 32. The signal source may be a baseband circuit, and the signal source may output a baseband signal.

The first coupler 10 is configured to output a first sub-signal and a second sub-signal based on an input signal. The first sub-signal is output to the delayer 20, and the second sub-signal is output to the filter circuit 30. The first coupler 10 may be configured to split the input signal into the first sub-signal and the second sub-signal. The input signal is an analog signal. The input signal is specifically a signal obtained after non-linear distortion is introduced into a signal output by the signal source, for example, may be a signal directly output by a component into which non-linear distortion is introduced, or may be a signal obtained after the directly output signal passes through another component. For example, the input signal is an output signal of a PA on a transmit channel. The input signal includes a wanted signal (which is referred to as a service signal below) and an intermodulation signal. Both the first sub-signal and the second sub-signal include an intermodulation signal and a service signal. The signal processing apparatus is configured to filter out the intermodulation signal to obtain the service signal. Power of the first sub-signal may be different from power of the second sub-signal. For example, the power of the first sub-signal is greater than the power of the second sub-signal.

The delayer 20 is configured to delay the first sub-signal to output a delayed signal to the second coupler 40. A delay amount of the delayer 20 may be preset, and the delay amount may be used to match a processing delay of the filter circuit 30.

The filter circuit 30 includes the plurality of filter sub-circuits 31 and the accumulation circuit 32. The plurality of filter sub-circuits 31 are separately configured to sample the second sub-signal at different sampling moments, and perform filtering processing on sampled signals obtained through sampling, to output sampled and filtered signals. The accumulation circuit 32 is configured to accumulate the sampled and filtered signals output by the plurality of filter sub-circuits 31, to obtain an intermodulation cancellation signal. In other words, the plurality of filter sub-circuits 31 may be separately configured to perform amplitude-phase adjustment on the second sub-signal, and the accumulation circuit 32 is configured to obtain the intermodulation cancellation signal obtained after the second sub-signal is adjusted.

The second coupler 40 is configured to perform cancellation on the delayed signal based on the intermodulation cancellation signal, and output a target signal. The second coupler 40 may subtract the intermodulation cancellation signal from the delayed signal to cancel an intermodulation signal in the delayed signal, to obtain the target signal.

Further, the signal processing apparatus may further include an amplifier 50a, and the amplifier 50a is coupled between the filter circuit 30 and the second coupler 40. The amplifier 50a is configured to amplify the intermodulation cancellation signal output by the filter circuit 30, so that an amplitude of the intermodulation cancellation signal can match an amplitude of the intermodulation signal in the delayed signal.

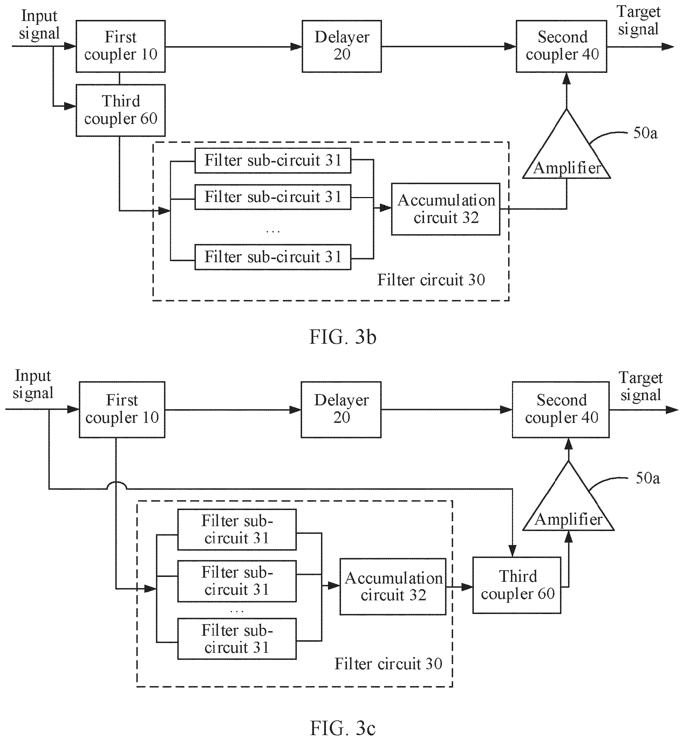

Optionally, the signal processing apparatus further includes a combiner module #22. As an example for description below, the combiner module #22 is a third coupler 60. As shown in FIG. 3b, a first input end of the third coupler 60 is coupled to the output end of the first coupler 10, to obtain the second sub-signal; a second input end of the third coupler 60 is coupled to the signal source; and an output end of the third coupler 60 is coupled to the input end of the filter circuit 30.

The third coupler 60 is configured to extract a first intermodulation signal from the second sub-signal. Optionally, a signal output by the signal source and the second sub-signal are separately input into the third coupler 60, and the third coupler 60 outputs the first intermodulation signal after cancellation. In other words, in the signals input into the third coupler 60, one is the second sub-signal, and the other is a signal that has a same source as the second sub-signal. The signal is used to extract the first intermodulation signal.

Optionally, the third coupler 60 may be replaced with the foregoing equalizer. In this case, a signal output by the equalizer is the first intermodulation signal. In other words, the combiner module #2 may be replaced with the foregoing equalizer.

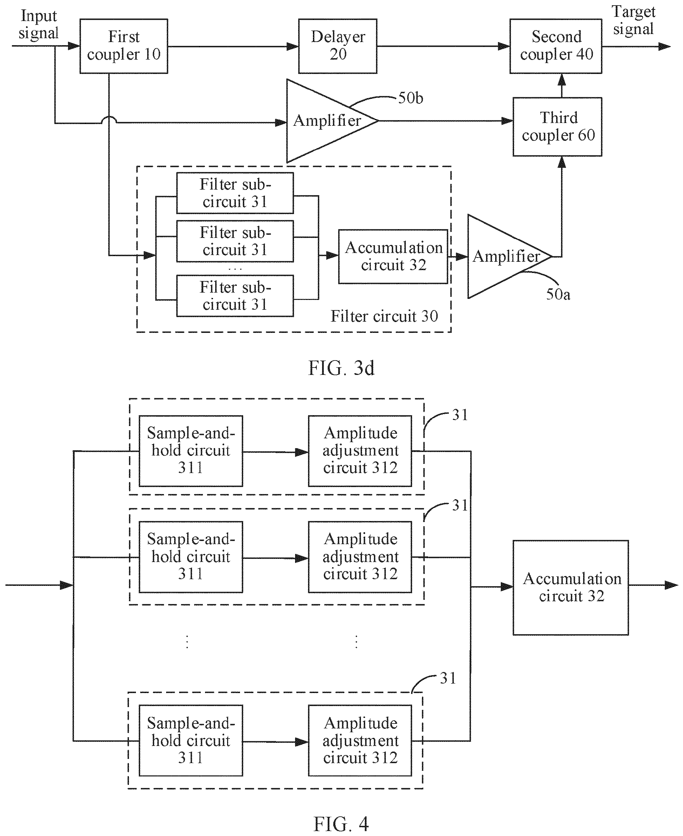

It may be understood that the third coupler 60 may be alternatively coupled between the filter circuit 30 and the second coupler 40. Alternatively, as shown in FIG. 3c, the third coupler 60 may be coupled between the filter circuit 30 and the amplifier 50a. Alternatively, as shown in FIG. 3d, the third coupler 60 may be coupled between the amplifier 50a and the second coupler 40. In other words, the first input end of the third coupler 60 may be alternatively coupled to the output end of the filter circuit 30 or an output end of the amplifier 50a, and the output end of the third coupler 60 may be alternatively coupled to the input end of the second coupler 40 or an input end of the amplifier 50a. It may be understood that, in FIG. 3d, the second input end of the third coupler 60 may be alternatively coupled to the amplifier 50b, and the input end of the amplifier 50b is coupled to the signal source. Through introduction of the amplifier 50b is introduced, a signal of the signal source that is input into the third coupler 60 can match power of the second sub-signal or the service signal in the second sub-signal.

Through introduction of the third coupler 60, the service signal may be reduced to some extent before the signal enters the second coupler 40, so that when the intermodulation cancellation signal is used to cancel the intermodulation signal in the delayed signal, adverse impact on a service signal component in the delayed signal can be reduced.

As an example for description below, the apparatus includes the third coupler 60 and the third coupler 60 is coupled between the first coupler 10 and the filter circuit 30, that is, as shown in FIG. 3b. It may be understood that, when the filter circuit 30 is directly coupled to the first coupler 10, the first intermodulation signal in the filter circuit 30 in the following description is replaced with the second sub-signal.

Optionally, the signal processing apparatus may further include an attenuator. The attenuator is coupled between the first coupler 10 and the third coupler 60. The attenuator is configured to attenuate the second sub-signal, so that an amplitude of the second sub-signal matches an amplitude of a service signal that is input into the third coupler 60.

Further, as shown in FIG. 4, each of the plurality of filter sub-circuits 31 includes a sample-and-hold circuit 311 and an amplitude adjustment circuit 312. The sample-and-hold circuit 311 is configured to sample and keep the first intermodulation signal at a sampling moment corresponding to the filter sub-circuit 31, to output a sampled signal. The amplitude adjustment circuit 312 is configured to perform filtering processing on the sampled signal, to adjust an amplitude and a phase of the sampled signal, and output a sampled and filtered signal. Sampling and keeping may be understood as: after a sampling value is obtained at the sampling moment, keeping the sampling value in a period of time for a subsequent procedure; and in addition, after a new sampling value is obtained at a next sampling moment, keeping the new sampling value in a next period of time for a subsequent procedure. Keeping may also be understood as maintaining, retaining, or saving.

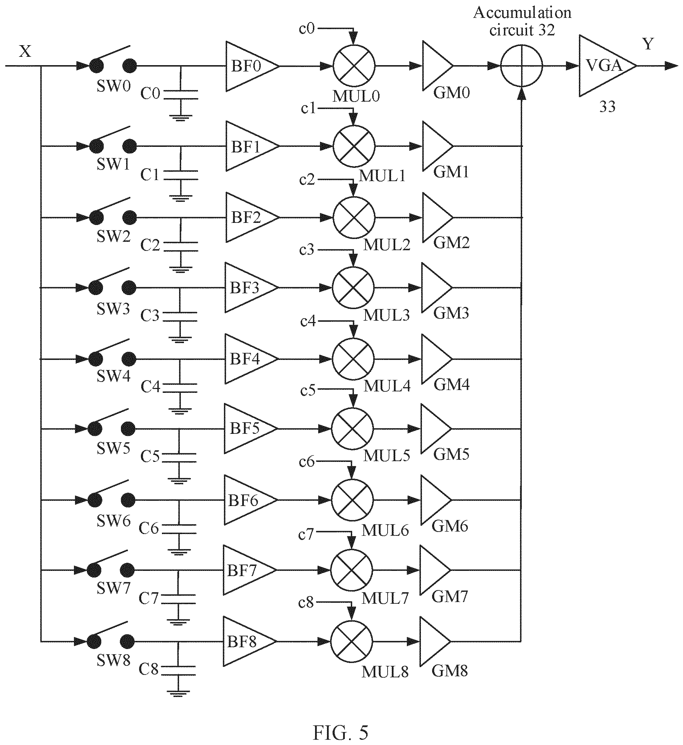

In a possible embodiment, the filter circuit 30 may be a switched-capacitor analog filter, the switched-capacitor analog filter may be in a form of a plurality of phases, and each phase in the plurality of phases may correspond to one filter sub-circuit 31. As shown in FIG. 5, for each filter sub-circuit 31, the sample-and-hold circuit 311 may include a switch SW, a capacitor C, and a buffer BF; and the amplitude adjustment circuit 312 includes a multiplier MUL. Optionally, the amplitude adjustment circuit 312 may further include a transconductance amplifier GM. A first end of the switch SW is an input end of the filter sub-circuit 31; a second end of the switch SW, a first end of the capacitor C, and a first end of the buffer BF are coupled; a second end of the capacitor C is grounded; a second end of the buffer BF is coupled to a first input end of the multiplier MUL; a second input end of the multiplier MUL is configured to receive a filtering coefficient c; an output end of the multiplier MUL is coupled to an input end of the transconductance amplifier GM; and an output end of the transconductance amplifier GM is an output end of the filter sub-circuit 31.

It should be noted that FIG. 5 is described by using an example in which the plurality of filter sub-circuits 31 include nine filter sub-circuits 31, and a switch, a capacitor, a buffer, a multiplier, and a transconductance amplifier in an $i^{th}$ filter sub-circuit 31 in the nine filter sub-circuits 31 and a filtering coefficient corresponding to the multiplier are respectively represented as $SW_i$, $C_i$, $BF_i$, $MUL_i$, $GM_i$, and $c_i$, where a value range of i is 0 to 8.

Specifically, in the $i^{th}$ filter sub-circuit 31, the switch $SW_i$ and the capacitor $C_i$ may be configured to sample the first intermodulation signal at a sampling moment corresponding to the filter sub-circuit 31, the buffer $BF_i$ may be configured to keep the sampled signal, the multiplier $MUL_i$ may be configured to adjust an amplitude of the sampled signal based on the filtering coefficient $c_i$, and the transconductance amplifier $GM_i$ may be configured to amplify power of the adjusted sampled signal. Filtering coefficients c corresponding to multipliers MULs in different filter sub-circuits 31 may be different. Amplification multiples of transconductance amplifiers GMs in different filter sub-circuits 31 may also be different. Buffers BFs in different filter sub-circuits 31 keep the sampled signal for a same time length.

Optionally, opening or closing of the switch SW may be controlled by a controller. Filtering coefficients c of multipliers MULs in different filter sub-circuits 31 may be set by the controller. Amplification multiples of transconductance amplifiers GMs in different filter sub-circuits 31 may be set by the controller. The controller may be a controller of a device to which the signal processing apparatus is applied. For example, the controller may be a processor or a system on chip (system of chip, SoC).

For example, in the signal processing apparatus, it is assumed that the first intermodulation signal is represented as X, the intermodulation cancellation signal output by the filter circuit 30 is represented as Y, a signal output by the delayer is represented as Y', a signal output by the amplifier 50 after amplifying the intermodulation cancellation signal Y is represented as Gain×Y, a target signal output by the second coupler 40 is Error, and a sequence including the plurality of filtering coefficients is represented as Cn. In this case, Error needs to meet the following formula (1), where $\otimes$ in the formula represents a convolution operation.

$$Error = Y' - Gain \times Y = Y' - Gain \times Cn \otimes X \qquad (1)$$

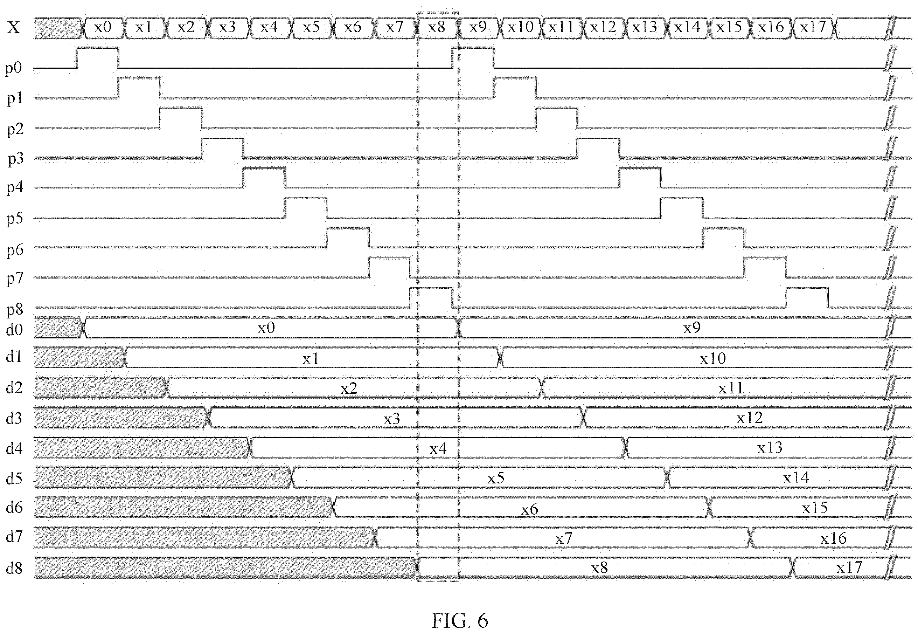

FIG. 6 is a diagram of a working time sequence of the filter circuit 30 corresponding to FIG. 5. A working principle of the filter circuit 30 is described in detail below with reference to FIG. 6. In FIG. 6, X represents the first intermodulation signal, x1 to x17 represent data streams of the first intermodulation signal X at different moments, and p0 to p8 respectively represent drive signals of the sample-and-hold circuit 311 in the nine filter sub-circuits 31. The sample-and-hold circuit 311 temporarily performs sampling and keeping on a rising edge of a corresponding drive signal, and temporarily performs sampling and keeping again until a next rising edge of the drive signal arrives. For example, when a first rising edge of p0 arrives, SW0, C0, and BF0 obtain a value of X at this moment through sampling, record the value as x0, and keep the value until a next rising edge of p0 arrives. It may be understood that, in a period of time before the sampling value x0 is obtained, the next rising edge of p0 arrives, and a new sampling value x9 is obtained, a value output from the BF0 to MUL0 is always x0. It may be understood that rising edges of p0 to p8 are used to trigger sampling, and falling edges may have no function on the filter sub-circuit. It may be understood that, in a specific implementation process, the rising edge of the drive signal may not be manifested as instantaneous jump. In this case, temporarily performing sampling and keeping on the rising edge of the drive signal may be performing sampling and keeping at a moment at which a change of the drive signal reaches a specified threshold.

Sampling signals obtained after the nine filter sub-circuits 31 perform sampling and keeping based on the foregoing process are respectively represented as d0 to d8; in other words, d0 to d8 are respectively sampling signals output by sample-and-hold circuits 311 in the nine filter sub-circuits 31. It is assumed that a moment corresponding to x8 is an output moment of the filter circuit 30, and if filtering coefficients corresponding to p0 to p8 are respectively c0 to c8, signals that are correspondingly output by the filter circuit 30 at different moments meet the following formula (2):

$$y(8) = c0 \times x0 + c1 \times x1 + c2 \times x2 + c3 \times x3 + c4 \times x4 + c5 \times x5 + c6 \times x6 + c7 \times x7 + c8 \times x8$$

$$y(9) = c0 \times x9 + c1 \times x1 + c2 \times x2 + c3 \times x3 + c4 \times x4 + c5 \times x5 + c6 \times x6 + c7 \times x7 + c8 \times x8$$

$$y(10) = c0 \times x9 + c1 \times x10 + c2 \times x2 + c3 \times x3 + c4 \times x4 + c5 \times x5 + c6 \times x6 + c7 \times x7 + c8 \times x8$$

$$y(11) = c0 \times x9 + c1 \times x10 + c2 \times x11 + c3 \times x3 + c4 \times x4 + c5 \times x5 + c6 \times x6 + c7 \times x7 + c8 \times x8$$

$$y(12) = c0 \times x9 + c1 \times x10 + c2 \times x11 + c3 \times x12 + c4 \times x4 + c5 \times x5 + c6 \times x6 + c7 \times x7 + c8 \times x8$$

$$\ldots\ldots \qquad (2)$$

The foregoing controller may directly configure or input a filtering coefficient or input corresponding to each filter sub-circuit 31, or the calculation circuit 82 may obtain a filtering coefficient corresponding to each filter sub-circuit 31 through calculation and input the filtering coefficient into each filter sub-circuit. Filtering coefficients corresponding to the filter sub-circuits 31 may have different values at different moments. A value of the filtering coefficient and a change of the filtering coefficient may be controlled by the foregoing controller. For example, at a moment corresponding to x8, a filtering coefficient corresponding to a first filter sub-circuit is c0, and a filtering coefficient corresponding to a second filter sub-circuit is c1; and at a moment corresponding to x9, the filtering coefficient corresponding to the first filter sub-circuit may be changed to c0', and the filtering coefficient corresponding to the second filter sub-circuit may be changed to c1'.

Optionally, as shown in FIG. 5, the filter circuit 30 may further include a variable-gain amplifier (variable-gain amplifier, VGA) 33 coupled to the output end of the accumulation circuit 32. The VGA 33 may be configured to amplify a gain of the intermodulation cancellation signal output by the filter circuit 30, so that the gain of the intermodulation cancellation signal can match a gain of an intermodulation signal in a transmit delayed signal.

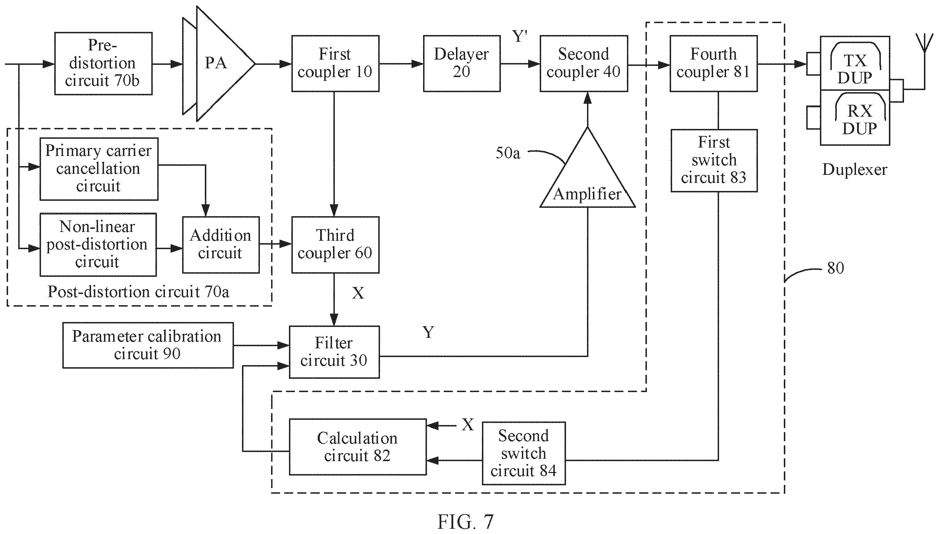

In a possible embodiment, as shown in FIG. 7, the apparatus further includes a post-distortion circuit 70a coupled to the third coupler 60. An input end of the post-distortion circuit 70a is configured to receive a first service signal, and the first service signal is a signal output by the signal source of the signal processing apparatus. The first service signal may be a signal used to be input into the non-linear distortion component. For example, the first service signal may be a baseband signal generated by a baseband circuit, and a signal obtained after power of the first service signal is amplified is the foregoing input signal of the signal processing apparatus. Optionally, the post-distortion circuit 70a includes a primary carrier cancellation circuit, configured to provide the first service signal. The primary carrier cancellation circuit may be implemented by using a digital adaptive filter, to compensate for amplitude-phase flatness of a hardware link. Optionally, the post-distortion circuit 70a further includes a non-linear post-distortion circuit and an addition circuit. The non-linear post-distortion circuit is configured to inject a second intermodulation signal into the first service signal. The addition circuit is configured to: add the first service signal and the second intermodulation signal to obtain a second service signal, and output the second service signal to the third coupler 60. After receiving the second service signal, the third coupler 60 may subtract the second service signal from the second sub-signal, to obtain the first intermodulation signal. A difference between a frequency of the second intermodulation signal and a frequency of the first service signal is greater than or equal to a first threshold, and the second intermodulation signal may be referred to as a far-end intermodulation signal. A difference between a frequency of the first intermodulation signal and the frequency of the first service signal is less than the first threshold, and the first intermodulation signal may be referred to as a near-end intermodulation signal. In other words, the non-linear post-distortion circuit and the addition circuit are further introduced, so that the third coupler 60 can further filter out an intermodulation signal that is not in a receive frequency band from the first sub-signal, and therefore, processing of the filter circuit 30 focuses on an intermodulation signal in the receive frequency band, thereby helping improve a cancellation effect for the intermodulation signal in the receive frequency band. The intermodulation signal that is not in the receive frequency band may be filtered out by a filter in a subsequent step of the communication device. It may be understood that the third coupler 60 may be further coupled to a position shown in FIG. 3c or FIG. 3d. In this case, the post-distortion circuit 70a may also be coupled to the third coupler 60. When the third coupler 60 is coupled to the position shown in FIG. 3d, the amplifier 50b may be coupled between the post-distortion circuit 70a and the third coupler 60.

In another possible embodiment, as shown in FIG. 7, the apparatus further includes a pre-distortion circuit 70b. The pre-distortion circuit 70b is located before the non-linear distortion component. For example, the pre-distortion circuit is coupled to an input end of the PA. The pre-distortion circuit 70b may also be referred to as a non-linear pre-distortion circuit, and is configured to inject a third intermodulation signal into the first service signal, to obtain a pre-distortion signal. After the pre-distortion passes through the non-linear distortion component, distortion caused by the non-linear component may be canceled to some extent, thereby reducing an intermodulation signal in an output signal of the non-linear component. The third intermodulation signal is a near-end intermodulation signal. The pre-distortion circuit 70b may be implemented by using a digital adaptive filter.

Further, as shown in FIG. 7, the apparatus further includes a filtering coefficient calculation circuit 80. The filtering coefficient calculation circuit 80 has two input ends, and the two input ends are respectively used to receive the first intermodulation signal and the target signal. The filtering coefficient calculation circuit 80 is configured to output a plurality of filtering coefficients based on the first intermodulation signal and the target signal, and the plurality of filtering coefficients are filtering coefficients of the plurality of filter sub-circuits 31. Optionally, the filtering coefficient calculation circuit 80 may output the plurality of filtering coefficients to the controller, and the controller allocates the plurality of filtering coefficients to different filter sub-circuits 31 in the plurality of filter sub-circuits 31.

In a possible embodiment, the filtering coefficient calculation circuit 80 includes a splitter module #12 and a calculation circuit 82. As described above, the splitter module may be a component such as a coupler or a splitter. A fourth coupler 81 is used as an example of the splitter module #12 below for description. An input end of the fourth coupler 81 is coupled to the output end of the second coupler 40, a first output end of the fourth coupler 81 is coupled to a first input end of the calculation circuit 82, and a second input end of the calculation circuit 82 is configured to receive the first intermodulation signal. The fourth coupler 81 is configured to obtain a target sub-signal from the target signal through coupling. For example, the fourth coupler 81 may be a splitter, and is configured to obtain the target sub-signal from the target signal through splitting. Power of the target sub-signal may be less than that of the target signal. The calculation circuit 82 is configured to output a plurality of filtering coefficients based on the first intermodulation signal and the target sub-signal. If the target transmit sub-signal is represented as Error, the first intermodulation signal is represented as X, and the plurality of filtering coefficients are represented as C(n) (n represents a quantity of iterations), a solving formula of the plurality of filtering coefficients may be represented as the following formula (3). In the formula, mu represents an iteration step of each iteration, and conj represents a conjugate operation.

$$C(n+1) = C(n) + mu \times \sum_{block} Error * conj(X) \qquad (3)$$

Further, as shown in FIG. 7, the apparatus further includes a parameter calibration circuit 90 coupled to the filter circuit 30. The parameter calibration circuit 90 has two input ends, and the two input ends are respectively configured to receive the first intermodulation signal and the intermodulation cancellation signal. The parameter calibration circuit 90 is configured to determine a mismatch parameter of the filter circuit 30 based on the first intermodulation signal and the intermodulation cancellation signal. The mismatch parameter is used to calibrate the filter circuit 30, so that performance of the filter sub-circuits is aligned. Optionally, the mismatch parameter includes at least one of the following: a sampling moment mismatch value, a gain mismatch value, or a direct current mismatch value.

The filter circuit 30 is essentially a filter of a multi-phase architecture. Because the filter circuit 30 is implemented by an analog circuit, a parameter mismatch, such as a sampling moment mismatch value, a gain mismatch value, or a direct current mismatch value, may exist between a plurality of phases in an actual application process. Assuming that the filter circuit 30 includes M filter sub-circuits 31 (that is, M phases), parameter adaptation causes spurious of $f_s / M \pm f_{in}$ in a spectrum of an output signal of the filter circuit 30. $f_{in}$ represents the frequency of the first intermodulation signal. Spurious energy caused by parameter mismatch meets the following formula (4), where X represents the first intermodulation signal, Y represents the intermodulation cancellation signal, C represents a filtering coefficient, and $\otimes$ represents a convolution operation.

$$P = \sum \left( Y - C \otimes X \right)^2 \tag{4}$$

It is assumed that the foregoing mismatch parameter is represented as S. A value of the mismatch parameter may be determined by injecting a known dither signal into X. If the known dither signal is represented as $\Delta$, two corresponding spurious energy $P_{\Delta 1}$ and $P_{\Delta 2}$ may be obtained after known dither signals ($\Delta 1$ and $\Delta 2$) are injected, and a mismatch value (or referred to as a correction value) of the mismatch parameter meets the following formula (5). In the formula, mu is a step of each iterative correction.

$$S(n+1) = S(n) - mu \times \frac{1}{\Delta 1 - \Delta 2} (P_{\Delta 1} - P_{\Delta 2}) \tag{5}$$

The foregoing parameter mismatch is corrected by using the parameter calibration circuit 90, so that spurious energy can be reduced and cancellation performance can be improved. Optionally, the parameter calibration circuit 90 may further send the determined mismatch parameter to the controller, so that the controller corrects the filter circuit 30 based on the corresponding mismatch parameter, thereby ensuring that cancellation performance of the apparatus is not affected by the spurious energy.

Further, as shown in FIG. 7, the apparatus further includes a power amplifier PA and a duplexer DUX. Before the power amplifier PA is coupled to the input end of the first coupler 10, the power amplifier PA is configured to amplify an output signal of the pre-distortion circuit 70b, or is configured to amplify the first service signal and output the signal to the first coupler 10. The duplexer DUX is coupled between the second output end of the fourth coupler 81 or the output end of the second coupler 40 and the antenna. The duplexer DUX is configured to: receive the target signal, perform transmit filtering processing on the target signal, and transmit a processed signal through the antenna.

It should be noted that the signal processing apparatus may alternatively not include the power amplifier PA or the duplexer DUX. For example, the power amplifier PA and the duplexer DUX may be disposed independently of the apparatus. The signal processing apparatus may also be referred to as a feedforward cancellation system. This is not specifically limited in this embodiment of this application.

The signal processing apparatus provided in this embodiment of this application may be applied to a multi-antenna scenario. In this case, a quantity of signal processing apparatuses may be the same as a quantity of power amplifiers PA. There may be no binding relationship between the quantity of signal processing apparatuses and a quantity of antennas, that is, one or more antennas may correspond to one signal processing apparatus.

Optionally, the filter circuit 30 may be further integrated into one chip with one or more of the post-distortion circuit 70a, the filtering coefficient calculation circuit 80, or the parameter calibration circuit 90.

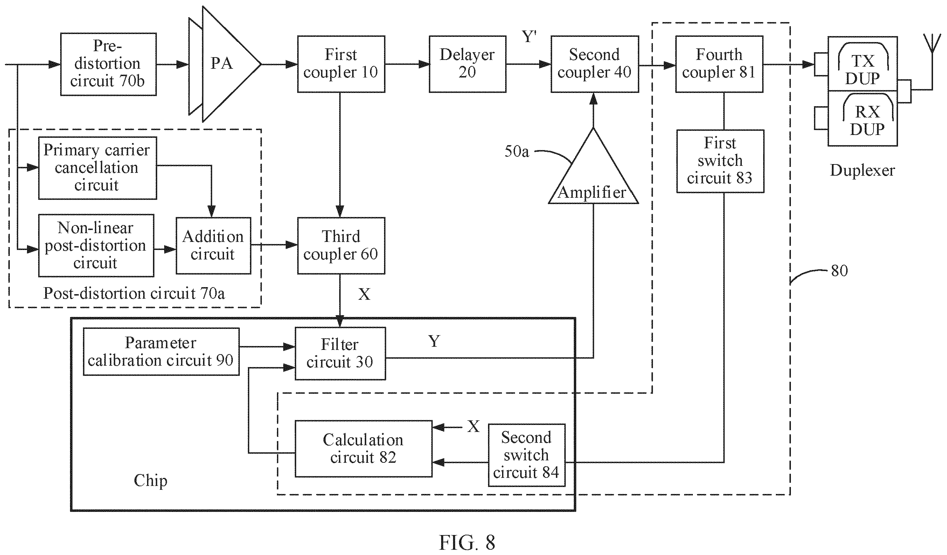

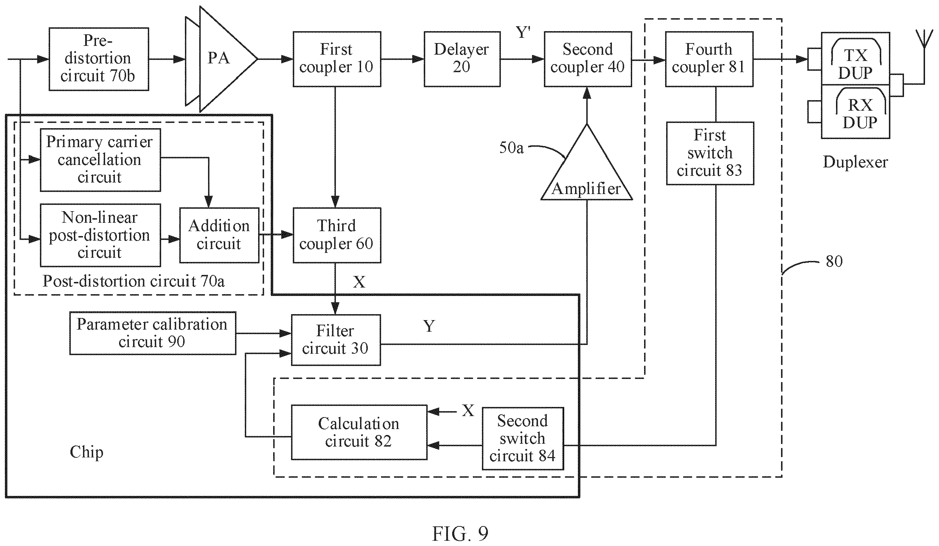

In an example, as shown in FIG. 8, the filter circuit 30 is integrated into one chip with the calculation circuit 81 in the filtering coefficient calculation circuit 80 and the parameter calibration circuit 90. In another example, as shown in FIG. 9, the filter circuit 30 is integrated into one chip with the post-distortion circuit 70a, the calculation circuit 81 in the filtering coefficient calculation circuit 80, and the parameter calibration circuit 90.

Optionally, when the calculation circuit 81 and the filter circuit 30 are integrated into one chip, the filtering coefficient calculation circuit 80 may further include a first switch circuit 83 and a second switch circuit 84 that are coupled between the fourth coupler 82 and the calculation circuit 81. The first switch circuit 83 may be disposed outside the chip, and the second switch circuit 84 may be integrated into the chip. In this way, a hardware link between the first switch circuit 83 and the second switch circuit 84 may further implement time division multiplexing; in other words, through opening and closing of the first switch circuit 83 and the second switch circuit 84, a plurality of fourth couplers 81 can share one calculation circuit 82, to improve utilization of the hardware link and reduce costs of the apparatus.

In this embodiment of this application, the first coupler 10 is configured to output the first sub-signal and the second sub-signal based on the input signal; the delayer 20 is configured to delay the first sub-signal to output the delayed signal; the third coupler 60 is configured to extract the first intermodulation signal in the second sub-signal; the filter circuit 30 includes the plurality of filter sub-circuits 31 and the accumulation circuit 32, and the plurality of filter sub-circuits 31 are respectively configured to perform analog domain sampling and filtering processing on the first intermodulation signal at different sampling moments; the accumulation circuit 32 is configured to accumulate sampled filtered signals output by the plurality of filter sub-circuits 31, to obtain the intermodulation cancellation signal; and the second coupler 40 is configured to output the target signal based on the intermodulation cancellation signal and the delayed signal. In other words, the plurality of filter sub-circuits 31 and the accumulation circuit 32 included in the filter circuit 30 can implement high-precision analog domain sampling and amplitude-phase adjustment of the first intermodulation signal in an analog signal domain by using a multi-phase sample-and-hold circuit and amplitude-phase adjustment. It may be understood that a larger quantity of phases in multi-phase, that is, a larger quantity of filter sub-circuits 31, indicates more sampling data of the first intermodulation signal at a moment and higher precision of amplitude-phase adjustment. In addition, because the filter circuit 30 performs processing in an analog domain, no additional analog-to-digital conversion is required, and a delay can be effectively reduced. Therefore, equalization processing of the intermodulation signal can be implemented when the delayer 20 provides an extremely small delay, thereby improving processing precision while reducing a processing delay. In addition, through the pre-distortion circuit 70b and the post-distortion circuit 70a, a cancellation effect for the intermodulation signal in the receive frequency band can be further improved, and system costs can be reduced. High performance of the filter circuit 30 can be further ensured by using the filtering coefficient calculation circuit 80 and the parameter calibration circuit 90.

Based on this, an embodiment of this application further provides a chip. The chip includes a filter circuit 30. For specific descriptions of the filter circuit, refer to the foregoing descriptions of the filter circuit 30. Details are not described herein again in this embodiment of this application.

In another aspect, an embodiment of this application further provides a communication device. The communication device may be a base station or a terminal. The communication device includes a baseband circuit and the signal processing apparatus provided in any one of FIG. 3a to FIG. 9. For specific descriptions of the signal processing apparatus, refer to the foregoing descriptions. Details are not described herein again in this embodiment of this application.

In the several embodiments provided in this application, it should be understood that the disclosed different apparatuses may be implemented in other manners. For example, the described apparatus embodiment is merely an example. For example, the module or division into the units is merely logical function division and may be other division in actual implementation. For example, a plurality of units or components may be combined or integrated into another apparatus, or some features may be ignored or not performed.

The units described as separate parts may or may not be physically separate, and parts displayed as units may be one or more physical units, may be located in one place, or may be distributed on different places. Some or all of the units may be selected based on actual requirements to achieve the objectives of the solutions of embodiments.

In addition, function units in embodiments of this application may be integrated into one processing unit, each of the units may exist alone physically, or two or more units are integrated into one unit. The integrated unit may be implemented in a form of hardware, or may be implemented in a form of a software functional unit.

In conclusion, the foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

**Claims**

1. A signal processing apparatus, comprising a first splitter module, a first combiner module, a delayer, and a filter circuit, wherein

   the first splitter module is coupled to a signal source of the signal processing apparatus, and an output end of the first splitter module is separately coupled to an input end of the delayer and an input end of the filter circuit;
   an output end of the delayer is coupled to a first input end of the first combiner module; and
   an output end of the filter circuit is coupled to a second input end of the first combiner module, the filter circuit comprises a plurality of filter sub-circuits and an accumulation circuit, and output ends of the plurality of filter sub-circuits are coupled to an input end of the accumulation circuit.

**2.** The apparatus according to claim 1, wherein each of the plurality of filter sub-circuits comprises:
a sample-and-hold circuit and an amplitude adjustment circuit, wherein an output end of the sample-and-hold circuit is coupled to a first input end of the amplitude adjustment circuit.

**3.** The apparatus according to claim 2, wherein the sample-and-hold circuit comprises a switch, a capacitor, and a buffer, and the amplitude adjustment circuit comprises a multiplier; and
a first end of the switch is an input end of the filter sub-circuit, a second end of the switch, a first end of the capacitor, and a first end of the buffer are coupled, a second end of the capacitor is grounded, and a second end of the buffer is coupled to a first input end of the multiplier.

**4.** The apparatus according to claim 3, wherein the amplitude adjustment circuit further comprises a transconductance amplifier coupled to an output end of the multiplier.

**5.** The apparatus according to any one of claims 1 to 4, wherein the filter circuit further comprises a variable-gain amplifier coupled to an output end of the accumulation circuit.

**6.** The apparatus according to any one of claims 2 to 5, wherein the apparatus further comprises a filtering coefficient calculation circuit; and
an output end of the filtering coefficient calculation circuit is coupled to a second input end of the amplitude adjustment circuit.

**7.** The apparatus according to claim 6, wherein the filtering coefficient calculation circuit comprises a second splitter module and a calculation circuit; and
an input end of the second splitter module is coupled to the output end of the first combiner module, a first output end of the second splitter module is coupled to a first input end of the calculation circuit, and a second input end of the calculation circuit is coupled to an output end of a second combiner module.

**8.** The apparatus according to any one of claims 1 to 7, wherein the apparatus further comprises a parameter calibration circuit coupled to the filter circuit.

**9.** The apparatus according to any one of claims 1 to 8, wherein the apparatus further comprises a second combiner module, a first input end of the second combiner module is coupled to the output end of the first splitter module, a second input end of the second combiner module is coupled to the signal source, and an output end of the second combiner module is coupled to the input end of the filter circuit.

**10.** The apparatus according to claim 9, wherein the apparatus further comprises an attenuator, and the attenuator is coupled between the first splitter module and the second combiner module.

**11.** The apparatus according to any one of claims 1 to 8, wherein the apparatus further comprises a second combiner module, a first input end of the second combiner module is coupled to the output end of the filter circuit, a second input end of the second combiner module is coupled to the signal source, and an output end of the second combiner module is coupled to the second input end of the first combiner module.

**12.** The apparatus according to claim 11, wherein the apparatus further comprises an amplifier coupled to the second input end of the second combiner module.

**13.** The apparatus according to any one of claims 9 to 12, wherein the apparatus further comprises a post-distortion circuit, and the post-distortion circuit is coupled between the signal source and the second combiner module.

**14.** The apparatus according to claim 13, wherein the post-distortion circuit comprises a digital adaptive filter.

**15.** The apparatus according to any one of claims 9 to 12, wherein the second combiner module is replaced with an equalizer.

**16.** The apparatus according to any one of claims 1 to 15, wherein the filter circuit is integrated into a chip.

**17.** The apparatus according to claim 16, wherein the filter circuit is integrated into the chip with at least one of the following: the filtering coefficient calculation circuit, the parameter calibration circuit, or the post-distortion circuit.

18. The apparatus according to any one of claims 1 to 17, wherein the apparatus further comprises a power amplifier coupled between an input end of the first splitter module and the signal source and a duplexer coupled to the output end of the first combiner module.

19. A communication device, wherein the communication device comprises a baseband circuit and the signal processing apparatus according to any one of claims 1 to 18.

FIG. 1

FIG. 2

FIG. 3a

FIG. 3b

FIG. 3c

Input signal → First coupler 10

Delayer 20 → Second coupler 40 → Target signal

Amplifier 50b → Third coupler 60

Filter sub-circuit 31
Filter sub-circuit 31
...
Filter sub-circuit 31

Accumulation circuit 32 → Amplifier 50a

Filter circuit 30

FIG. 3d

Sample-and-hold circuit 311 → Amplitude adjustment circuit 312 — 31

Sample-and-hold circuit 311 → Amplitude adjustment circuit 312 — 31

Accumulation circuit 32

Sample-and-hold circuit 311 → Amplitude adjustment circuit 312 — 31

FIG. 4

FIG. 5

FIG. 6

EP 4 418 535 A1

FIG. 7

FIG. 8

EP 4 418 535 A1

FIG. 9

EP 4 418 535 A1

## INTERNATIONAL SEARCH REPORT

| International application No. |
|---|
| **PCT/CN2021/131414** |

**A.    CLASSIFICATION OF SUBJECT MATTER**

H03F 1/32(2006.01)i

According to International Patent Classification (IPC) or to both national classification and IPC

**B.    FIELDS SEARCHED**

Minimum documentation searched (classification system followed by classification symbols)

H03F,H04B

Documentation searched other than minimum documentation to the extent that such documents are included in the fields searched

Electronic data base consulted during the international search (name of data base and, where practicable, search terms used)

CNKI, CNPAT, WPI, EPODOC: 非线性, 失真, 前馈, 分路, 合路, 耦合, 时延, 延时, 延迟, 滤波, 累加, 加法, 采样, 幅度, 幅值, 乘法, 跨导, 系数, 参数, 校准, nonlinear, distortion, feedforward, split+, combin+, delay, filter, add+, multipl+, sampl+, magnitude, coefficient, parameter, calibrat+

**C.    DOCUMENTS CONSIDERED TO BE RELEVANT**

| Category* | Citation of document, with indication, where appropriate, of the relevant passages | Relevant to claim No. |
|---|---|---|
| X | CN 105978493 A (COMBA TELECOM SYSTEMS (GUANGZHOU) LTD.) 28 September 2016 (2016-09-28) <br> description, paragraphs 27-34, and figure 2 | 1-8, 11-19 |
| Y | CN 105978493 A (COMBA TELECOM SYSTEMS (GUANGZHOU) LTD.) 28 September 2016 (2016-09-28) <br> description, paragraphs 27-34, and figure 2 | 9-10 |
| Y | CN 101572528 A (SUNWAVE COMMUNICATIONS CO., LTD.) 04 November 2009 (2009-11-04) <br> description, page 4 2nd-to-last paragraph to page 5 paragraph 2, and figure 2 | 9-10 |
| A | CN 103401515 A (WUHAN HONGXIN TELECOMMUNICATION TECHNOLOGIES CO., LTD.) 20 November 2013 (2013-11-20) <br> entire document | 1-19 |
| A | CN 1390063 A (SHANGHAI NO. 2 RESEARCH INSTITUTE OF SHENZHEN ZTE CORP.) 08 January 2003 (2003-01-08) <br> entire document | 1-19 |

☑ Further documents are listed in the continuation of Box C.      ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **13 July 2022** | **29 July 2022** |

| Name and mailing address of the ISA/CN | Authorized officer |
|---|---|
| **China National Intellectual Property Administration (ISA/CN)** <br> **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**

| International application No. |
| --- |
| **PCT/CN2021/131414** |

### C. DOCUMENTS CONSIDERED TO BE RELEVANT

| Category* | Citation of document, with indication, where appropriate, of the relevant passages | Relevant to claim No. |
| --- | --- | --- |
| A | CN 202495912 U (COMBA TELECOM SYSTEMS (CHINA) CO., LTD.) 17 October 2012 (2012-10-17) entire document | 1-19 |
| A | US 2009075612 A1 (CALIFORNIA INSTITUTE OF TECHNOLOGY) 19 March 2009 (2009-03-19) entire document | 1-19 |

Form PCT/ISA/210 (second sheet) (January 2015)

INTERNATIONAL SEARCH REPORT
Information on patent family members

| International application No. |
| --- |
| **PCT/CN2021/131414** |

| Patent document cited in search report | | | Publication date (day/month/year) | Patent family member(s) | | | Publication date (day/month/year) |
| --- | --- | --- | --- | --- | --- | --- | --- |
| CN | 105978493 | A | 28 September 2016 | None | | | |
| CN | 101572528 | A | 04 November 2009 | None | | | |
| CN | 103401515 | A | 20 November 2013 | None | | | |
| CN | 1390063 | A | 08 January 2003 | None | | | |
| CN | 202495912 | U | 17 October 2012 | None | | | |
| US | 2009075612 | A1 | 19 March 2009 | WO | 2009039289 | A2 | 26 March 2009 |

Form PCT/ISA/210 (patent family annex) (January 2015)